(19) Europäisches Patentamt / European Patent Office / Office européen des brevets

(11) **EP 4 050 347 A1**

(12) **EUROPÄISCHE PATENTANMELDUNG**

(43) Veröffentlichungstag:
**31.08.2022   Patentblatt 2022/35**

(21) Anmeldenummer: **21159313.2**

(22) Anmeldetag: **25.02.2021**

(51) Internationale Patentklassifikation (IPC):
**G01R 15/24** (2006.01)

(52) Gemeinsame Patentklassifikation (CPC):
**G01R 15/246**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
- **WETZEL, Ulrich**
  **91325 Adelsdorf (DE)**
- **ZETTNER, Jürgen**
  **90587 Veitsbronn (DE)**

(54) **VERFAHREN ZUM ÜBERWACHEN ZUMINDEST EINES HALBLEITERELEMENTS IN EINEM HALBLEITERMODUL**

(57)    Die Erfindung betrifft ein Verfahren zum Überwachen zumindest eines Halbleiterelements (4) in einem Halbleitermodul (2), wobei das Halbleitermodul (2) Zuleitungen (20, 22) zur Kontaktierung des Halbleiterelements (4) aufweist. Um dynamische, insbesondere transiente, Vorgänge erfassen zu können, ohne das zumindest eine Halbleiterelement (4) und dessen Peripherie merklich zu beeinflussen, wird vorgeschlagen, dass ein magneto-optischer Sensor (28) im Bereich des Halbleiterelements (4) oder zumindest einer Zuleitung (20, 22) angeordnet ist, wobei ein polarisiertes Lichtsignal (Lp) vom magneto-optischen Sensor (28) reflektiert wird, wobei anhand einer Polarisation des reflektierten Lichtsignals (Lr) ein
Strom ermittelt wird.

FIG 1

**Beschreibung**

Die Erfindung betrifft ein Verfahren zum Überwachen zumindest eines Halbleiterelements in einem Halbleitermodul.

Ferner betrifft die Erfindung eine Steuereinheit mit Mitteln zur Durchführung eines derartigen Verfahrens.

Überdies betrifft die Erfindung ein Computerprogramm zur Durchführung eines derartigen Verfahrens bei Ablauf in einer Steuereinheit.

Des Weiteren betrifft die Erfindung die Verwendung eines magneto-optischen Sensors zur Ermittlung eines Stromes in einem Halbleitermodul.

Darüber hinaus betrifft die Erfindung ein Halbleitermodul.

Derartige Halbleitermodule werden beispielsweise in einem Stromrichter in der elektrischen Antriebstechnik eingesetzt. Unter einem Stromrichter ist beispielsweise ein Gleichrichter, ein Wechselrichter, ein Umrichter oder ein Gleichspannungswandler zu verstehen. Derartige Stromrichter sind stetig weiterer Optimierung unterworfen, wodurch es zum Einsatz verbesserter Halbleitermaterialien, geänderter Aufbau und Verbindungstechniken, kurz AVT, sowie verbesserter Entwärmungskonzepte kommt. Darüber hinaus kommen Monitoring-Lösungen zur Überwachung der Halbleitermodule zum Einsatz. Derartige Optimierung zielen insbesondere auf hohe Leistungsdichten, kompakte Bauweisen, hohe Effizienz und gesteigerte Zuverlässigkeit ab.

Die Monitoring-Lösungen umfassen Sensoren, die beispielsweise eine Messung eines Laststromes, eine Messung einer Gatespannung und/oder einer Temperatur ermöglichen. Derartige Sensoren dürfen die Halbleiterelemente und deren Peripherie, welche beispielsweise die AVT, insbesondere Zuleitungen, umfasst, nicht merklich beeinflussen. Ferner ist eine schnelle Reaktion der Sensoren auf dynamische elektrische Vorgänge, insbesondere transiente Schaltvorgänge, der Halbleiterelemente, welche beispielsweise im ms-Bereich oder gar im $\mu$s-Bereich liegen, erforderlich.

Der Artikel "Magneto-Optical Sensors"; Koschny, Marco; Lindner, Morris; Richert, Hendryk, Quality (2012) vol. 51, S. 6-9; ISSN 03609936, beschreibt eine die Einführung von magneto-optischen Sensoren zur direkten Feldvisualisierung. Erwähnt wird auch das Prinzip von magneto-optischen Sensoren, welches der Faraday-Effekt ist.

Der Artikel "Rapid Faraday Rotation on $\varepsilon$-Iron Oxide Magnetic Nanoparticles by Visible and Terahertz Pulsed Light"; Shinichi Ohkoshi; Kenta Imoto; Asuka Namai; Marie Yoshikiyo; Seiji Miyashita; Hongsong Qiu; Shodai Kimoto; Kosaku Kato; Makoto Nakajima, Journal of the American Chemical Society, 2019, 141 (4), 1775-1780, beschreibt eine Magnetisierungsumkehr, die durch gepulste Laser mit sichtbarem Licht induziert wird und einen ultraschnellen dynamischen magneto-optischen Effekt, der durch gepulste Laserbestrahlung im Terahertzbereich auf chemisch synthetisierte magnetische Filme auf Basis von Gallium-Titan-Kobalt-substituiertem $\varepsilon$-Fe$_2$O$_3$ (GTC-$\varepsilon$-Fe$_2$O$_3$) und $\varepsilon$-Fe2O3-Nanopartikeln verursacht wird. Die Bestrahlung mit sichtbarem Licht gepulster Laser schaltet das Vorzeichen des Faraday-Effekts in GTC-E-Fe$_2$O$_3$-Filmen um. Auf der anderen Seite induziert die Bestrahlung des $\varepsilon$-Fe$_2$O$_3$-Films mit gepulstem THz-Licht eine ultraschnelle Faraday-Rotation in einer extrem kurzen Zeit von 400 fs.

Der Offenbarungsgehalt der Artikel "Magneto-Optical Sensors" und "Rapid Faraday Rotation on $\varepsilon$-Iron Oxide Magnetic Nanoparticles by Visible and Terahertz Pulsed Light" wird durch Verweis in die vorliegende Anmeldung mit einbezogen.

Vor diesem Hintergrund besteht die Aufgabe der vorliegenden Erfindung darin, ein Verfahren zum Überwachen zumindest eines Halbleiterelements in einem Halbleitermodul anzugeben, welches dynamische, insbesondere transiente, Vorgänge erfassen kann, ohne die Halbleiterelemente und deren Peripherie merklich zu beeinflussen.

Die Aufgabe wird erfindungsgemäß durch ein Verfahren zum Überwachen zumindest eines Halbleiterelements in einem Halbleitermodul gelöst, wobei das Halbleitermodul Zuleitungen zur Kontaktierung des Halbleiterelements aufweist, wobei ein magneto-optischer Sensor im Bereich des Halbleiterelements oder zumindest einer Zuleitung angeordnet ist, wobei ein polarisiertes Lichtsignal vom magneto-optischen Sensor reflektiert wird, wobei anhand einer Polarisation des reflektierten Lichtsignals ein Strom ermittelt wird.

Ferner wird die Aufgabe erfindungsgemäß gelöst durch ein Verfahren zum Überwachen zumindest eines Halbleiterelements in einem Halbleitermodul, wobei das Halbleitermodul Zuleitungen zur Kontaktierung des Halbleiterelements aufweist, wobei ein magneto-optischer Sensor im Bereich des Halbleiterelements oder zumindest einer Zuleitung angeordnet ist, wobei ein polarisiertes Lichtsignal vom magneto-optischen Sensor transmittiert wird, wobei anhand einer Polarisation des transmittierten Lichtsignals ein Strom ermittelt wird.

Überdies wird die Aufgabe erfindungsgemäß gelöst durch eine Steuereinheit mit Mitteln zur Durchführung eines derartigen Verfahrens.

Des Weiteren wird die Aufgabe erfindungsgemäß gelöst durch ein Computerprogramm zur Durchführung eines derartigen Verfahrens bei Ablauf in einer Steuereinheit.

Darüber hinaus wird die Aufgabe erfindungsgemäß gelöst durch die Verwendung eines magneto-optischen Sensors zur Ermittlung eines Stromes in einem Halbleitermodul.

Ferner wird die Aufgabe erfindungsgemäß gelöst durch ein Halbleitermodul aufweisend zumindest ein Halbleiterelement und Zuleitungen zur Kontaktierung des Halbleiterelements, eine Lichtquelle, welche zur Erzeugung eines polarisierten Lichtsignals konfiguriert ist, einen magneto-optischen Sensor, welcher im Bereich des Halbleiterelements oder zumindest einer Zuleitung angeordnet ist und welcher konfiguriert ist, das von der Lichtquelle erzeugte polarisierte Lichtsignal zu reflektieren, eine Detektionseinheit, welche zur Umwandlung des reflektierten Lichtsignals in ein elektrisches Signal konfiguriert ist und eine Auswerteeinheit, welche konfiguriert ist anhand einer Polarisation des reflektierten Lichtsignals einen Strom zu ermitteln.

Des Weiteren wird die Aufgabe erfindungsgemäß gelöst durch ein Halbleitermodul aufweisend zumindest ein Halbleiterelement und Zuleitungen zur Kontaktierung des Halbleiterelements, eine Lichtquelle, welche zur Erzeugung eines polarisierten Lichtsignals konfiguriert ist, einen magneto-optischen Sensor, welcher im Bereich des Halbleiterelements oder zumindest einer Zuleitung angeordnet ist und welcher konfiguriert ist, das von der Lichtquelle erzeugte polarisierte Lichtsignal zu transmittieren, eine Detektionseinheit, welche zur Umwandlung des transmittierten Lichtsignals in ein elektrisches Signal konfiguriert ist und eine Auswerteeinheit, welche konfiguriert ist anhand einer Polarisation des transmittierten Lichtsignals einen Strom zu ermitteln.

Darüber hinaus wird die Aufgabe erfindungsgemäß gelöst durch einen Stromrichter mit mindestens einem derartigen Halbleitermodul.

Die in Bezug auf das Verfahren nachstehend angeführten Vorteile und bevorzugten Ausgestaltungen lassen sich sinngemäß auf die Steuereinheit, das Computerprogramm, die Verwendung, das Halbleitermodul und den Stromrichter übertragen.

Der Erfindung liegt die Überlegung zugrunde, eine sensorbasierte Überwachung eines Halbleiterelements zu verbessern, indem ein magneto-optischer Sensors zur galvanisch getrennten Ermittlung eines Stromes in einem Halbleitermodul verwendet wird. Der magneto-optischer Sensor weist einen Werkstoff, insbesondere einen Dünnschicht-Film, mit magneto-optischen Eigenschaften auf. Beispielsweise enthält die magneto-optische Schicht Granat. Ein derartiger magneto-optischer Sensor wird im Bereich eines Halbleiterelements oder einer Zuleitung des Halbleiterelements angeordnet. Eine Lichtquelle erzeugt ein polarisiertes Lichtsignal, welches auf den magneto-optischen Sensor trifft und transmittiert oder reflektiert wird. Beispielsweise umfasst der magneto-optische Sensor auf einer der Lichtquelle abgewandten Seite eine, insbesondere metallische, Reflexionsschicht zur Reflexion des Lichtsignals. Aufgrund magneto-optischer Effekte, welche bei einer Transmission Faraday Effekt und bei einer Reflexion Kerr-Effekt genannt werden, sind Magnetfelder dadurch, insbesondere quantitativ, erfassbar, dass elektrisch aktive optische Kristalle oder Flüssigkeiten im magneto-optischen Sensor eine Polarisationsänderung verursachen, welche von der Feldstärke des Magnetfeldes abhängig ist. Über eine Detektionseinheit, welche z.B. einen opto-elektronischen Wandler mit einem vorgeschalteten Polarisationsfilter umfasst, wird das transmittierte oder reflektierte Lichtsignal in ein elektrisches Signal umwandelt. Beispielsweise weist der opto-elektronische Wandler zumindest eine lichtempfindliche Diode, z.B. eine Fotodiode oder eine Pin-Diode, auf. Insbesondere wird eine Lichtintensität des transmittierten oder reflektierten Lichtsignals über zumindest eine lichtempfindliche Diode, z.B. Fotodiode oder Pin-Diode, in einen Strom konvertiert. Anhand der Polarisation des transmittierten oder reflektierten Lichtsignals wird in einer Auswerteeinheit ein Strom ermittelt. Bei einer Reflexion des Lichtsignals durch den magneto-optischen Sensor durchdringt das Licht zwei Mal, auf dem Hin-und Rückweg, dieselbe magneto-optischen Schicht, sodass die Polarisationsänderung verstärkt wird. Daher ist beispielsweise eine dünnere Schicht verwendbar. Insbesondere magneto-optische Dünnschichten weisen genügend Sensitivität zur Erfassung von typischen Stromdichten, d.h. von Magnetfeldern im Bereich von Halbleiterelementen, auf. Die Ermittlung des Stromes mittels des magneto-optischen Sensors erfolgt galvanisch getrennt, sodass die Halbleiterelemente und deren Peripherie zumindest nicht merklich beeinflusst werden.

Eine weitere Ausführungsform sieht vor, dass das polarisierte Lichtsignal über einen Lichtleiter zum magneto-optischen Sensor geleitet wird. Insbesondere weist der Lichtleiter Lichtleitfasern auf, welche polarisationserhaltend ausgeführt sind. Beispielsweise weist der Lichtleiter Polymerfasern auf. Durch den Lichtleiter wird eine Störanfälligkeit reduziert und Bauraum eingespart.

Eine weitere Ausführungsform sieht vor, dass zumindest ein Teil des Lichtleiters und der magneto-optische Sensor innerhalb des Substrats verlaufend angeordnet sind, wobei das polarisierte Lichtsignal innerhalb des Substrats auf den magneto-optischen Sensor geleitet wird. Insbesondere sind zumindest ein Teil des Lichtleiters und der magneto-optische Sensor derartig im Substrat integriert, dass eine Fixierung stattfindet, sodass Vibrationen, welche eine Detektion von Polarisationsänderungen stören können, unterdrückt werden und insbesondere kleine magnetoptisch induzierte Polarisations-Drehwinkel sicher detektiert werden. Ferner ermöglicht eine Integration in das Substrat, welches elektrooptische Leiterplatte, kurz EOCB, genannt wird, eine nähere Positionierung des magneto-optischen Sensors und eine Miniaturisierung der Sensorik.

Eine weitere Ausführungsform sieht vor, dass anhand der Polarisation des Lichtsignals eine zweidimensionale Stromdichteverteilung ermittelt wird. Zur Ermittlung einer zweidimensionalen Stromdichteverteilung werden beispielsweise ein zweidimensionales Detektor-Array mit einer Mehrzahl an lichtempfindlichen Dioden und ein großflächiger magneto-optischer Sensor herangezogen. Insbesondere bei der Überwachung einer zweidimensionalen Stromdichteverteilung des zumindest einen Halbleiterelements sind Auffälligkeiten, welche zu einem Ausfall der Komponente führen können, frühzeitig erkennbar.

Eine weitere Ausführungsform sieht vor, dass der magneto-optische Sensor einen magneto-optischen Dünnschicht-Film aufweist, wobei ein transientes Stromsignal, insbesondere mit einer Amplituden Dynamik von mindestens 100 und einer Anstiegzeit im Bereich von maximal 10 μm, erfasst wird. Magneto-optische Effekte erfolgen in der Regel hochdynamisch, sodass magneto-optische Schichten schnellen Halbleiter-StromTransienten bei An- und Abschaltvorgängen leicht folgen können. Insbesondere durch schnelle lichtempfindliche Dioden, wie Fotodioden, sind mit wenig Schaltungsaufwand lokale Stromtransiente galvanisch getrennt erfassbar.

Eine weitere Ausführungsform sieht vor, dass das transiente Stromsignal durch Unterabtastung ermittelt wird. Insbesondere bei periodischen Signalen ist mittels einer Unterabtastung ein genauer Signalverlauf des schnellen transienten Stromsignals ermittelbar.

Eine weitere Ausführungsform sieht vor, dass die Unterabtastung durch ein Umrichtertaktsignal getriggert wird, wobei das Umrichtertaktsignal definiert verzögert wird. Durch eine Triggerung mit dem Umrichtertaktsignal wird eine zuverlässige Synchronisation ermöglicht. Eine definierte Verzögerung findet beispielsweise über ein, insbesondere analoges, Verzögerungsglied, beispielsweise eine Allpassschaltung, statt. Durch eine definierte Verzögerung ist eine Unterabtastung einfach und kostengünstig realisierbar.

Eine weitere Ausführungsform sieht vor, dass eine Temperatur des magneto-optischen Sensors ermittelt wird, wobei der Strom in Abhängigkeit der Temperatur des magneto-optischen Sensors und der Polarisation des Lichtsignals ermittelt wird. Die Temperatur des magneto-optischen Sensors wird beispielsweise optisch über ein zusätzliches IR-Lichtsignal. Ein Abgleich des temperaturabhängigen Polarisationsverhalten kann empirisch mittels einer Lookup-Table, mittels eines Modells und/oder mit Hilfe eines digitalen Zwillings erfolgen. Da ein Polarisationsverhalten des magneto-optischen Sensors temperaturabhängig ist, wird durch eine, insbesondere gleichzeitige, Temperaturmessung des magneto-optischen Sensors eine Genauigkeit der Ermittlung des Stromes verbessert.

Eine weitere Ausführungsform sieht vor, dass der magneto-optische Sensor ein erstes magneto-optisches Material und ein zweites magneto-optisches Material, welches sich hinsichtlich einer Empfindlichkeit vom ersten magneto-optischen Material unterscheidet, umfasst, wobei das erstes magneto-optische Material für die Ermittlung eines ersten Stromes verwendet wird, wobei das zweite magneto-optische Material für die Ermittlung eines zweiten Stromes verwendet wird und wobei der zweite Strom höher als der erste Strom ist. Dadurch wird eine Vergrößerung einer Messdynamik erreicht.

Im Folgenden wird die Erfindung anhand der in den Figuren dargestellten Ausführungsbeispiele näher beschrieben und erläutert.

Es zeigen:

FIG 1    eine schematische Darstellung einer ersten Ausgestaltung eines Halbleitermoduls im Querschnitt,

FIG 2    eine schematische Darstellung einer zweiten Ausgestaltung eines Halbleitermoduls im Querschnitt,

FIG 3    eine dreidimensionale schematische Darstellung einer dritten Ausgestaltung eines Halbleitermoduls,

FIG 4    eine schematische Darstellung einer vierten Ausgestaltung eines Halbleitermoduls im Querschnitt,

FIG 5    eine schematische Darstellung einer fünften Ausge-staltung eines Halbleitermoduls im Querschnitt,

FIG 6    eine schematische Darstellung einer sechsten Ausge-staltung eines Halbleitermoduls,

FIG 7    eine vergrößerte schematische Darstellung eines mag-neto-optischen Sensors und

FIG 8    eine schematische Darstellung eines Stromrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugzeichen haben in den verschiedenen Figuren die gleiche Bedeutung.

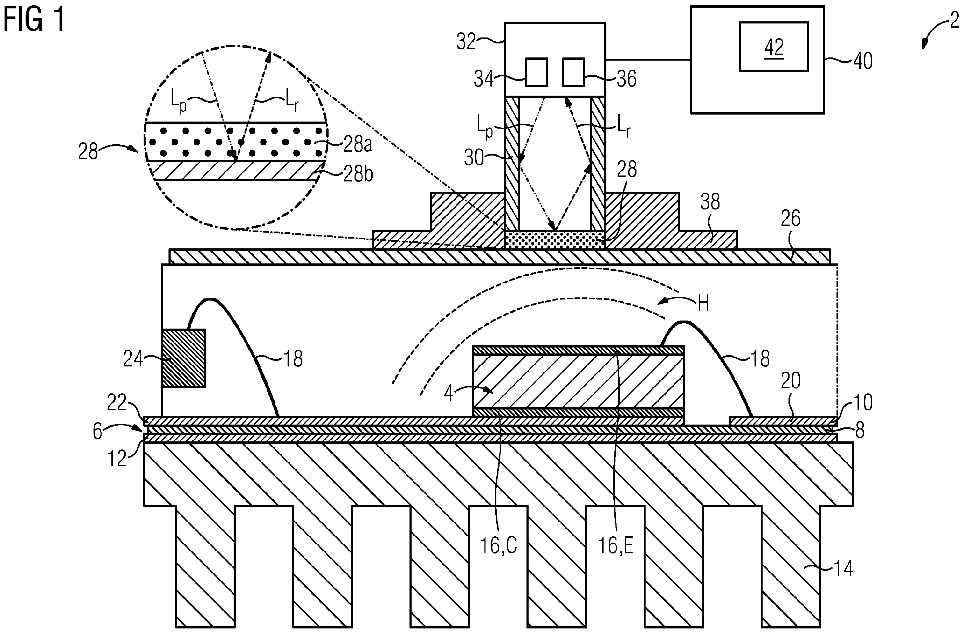

FIG 1 zeigt eine schematische Darstellung einer ersten Ausgestaltung eines Halbleitermoduls 2 im Querschnitt. Das Halbleitermodul 2 weist ein Halbleiterelement 4 und ein Substrat 6 auf, wobei das Halbleiterelement 4 exemplarisch als Insulated-Gate-Bipolar-Transistor (IGBT) ausgeführt ist. Das Halbleiterelement 4 kann auch als Metalloxide-Semiconductor-Field-Effect-Transistor (MOSFET), als Feldeffekttransistor, als Diode, als Logikbaustein, insbesondere als Field Programmable Gate Array (FPGA) oder als ein anderer Halbleiter ausgeführt sein. Insbesondere weist das Halbleiterelement 4 eine Fläche von mindestens 10 mm$^2$ auf. Das Substrat 6 umfasst eine dielektrische Materiallage 8, die einen keramischen Werkstoff, beispielsweise Aluminiumnitrid oder Aluminiumoxid, oder einen organischen Werkstoff, beispielsweise einem Polyamid enthält. Ferner weist die dielektrische Materiallage 8 eine Dicke d von 25 $\mu$m bis 400 $\mu$m, insbesondere 50 $\mu$m bis 250 $\mu$m, auf. Darüber hinaus umfasst das Substrat 6 auf einer dem Halbleiterelement 4 zugewandten Seite eine, insbesondere strukturierte, obere Metallisierung 10 und auf einer dem Halbleiterelement 4 abgewandten Seite eine untere Metallisierung 12, wobei die obere Metallisierung 10 und die untere Metallisierung 12 beispielsweise aus Kupfer hergestellt sind und auch Kupferkaschierung genannt werden. Die untere Metallisierung 12 des Substrats 6 ist, insbesondere stoffschlüssig, mit einem Kühlkörper 14 verbunden.

Das beispielhaft als IGBT ausgeführte Halbleiterelement 4 weist auf einer dem Substrat 6 zugewandten Seite ein Kontaktierungselement 16 auf, welches als Kollektor-Kontakt C ausgeführt ist, wobei ein weiteres Kontaktierungselement 16, welches als Emitter-Kontakt E ausgeführt ist, auf einer dem Substrat 6 abgewandten Seite angeordnet ist. Ein Gate-Kontakt des IGBTs ist aus Gründen der Übersichtlichkeit in FIG 1 nicht dargestellt. Der Emitter-Kontakt E ist über eine Bondverbindung 18 mit einer ersten Zuleitung 20 der oberen Metallisierung 10 des Substrats 6 verbunden, wobei der Kollektor-Kontakt C des Halbleiterelements 4 stoffschlüssig mit einer von der ersten Zuleitung 20 elektrisch isolierten zweiten Zuleitung 22 der oberen Metallisierung 10 verbunden ist. Die stoffschlüssige Verbindung ist durch Löten oder Sintern hergestellt. Die zweite Zuleitung 22 ist über eine Bondverbindung 18 mit einem elektrischen Anschlusselement 24 verbunden. Das Halbleitermodul 2 umfasst darüber hinaus ein Gehäuse 26, welches beispielsweise aus einem dielektrischen Werkstoff, insbesondere einem Kunststoff, hergestellt ist.

Ferner weist das Halbleitermodul 2 einen magneto-optischen Sensor 28 auf, welcher oberhalb des Halbleiterelements 4 mit dem Gehäuse 26 kontaktiert ist. Durch die in FIG 1 dargestellte Anordnung ist der magneto-optische Sensor 28 unter Nutzung des Kerr-Effektes konfiguriert zur Überwachung eines Stromes, insbesondere einer Stromtransienten, des Halbleiterelements 4, wobei der magneto-optische Sensor 28 galvanisch getrennt vom Halbleiterelement 4 in einem Magnetfeld H des Halbleiterelements 4 angeordnet ist. Der magneto-optische Sensor 28 ist aus einer magneto-optischen Schicht 28a, welche beispielsweise Granat enthält, und einer reflektierenden Schicht 28b, welche beispielsweise auf die magneto-optische Schicht 28a aufgesputtert ist, aufgebaut. Die magneto-optische Schicht 28a weist insbesondere einen Dünnschicht-Film mit magneto-optischen Eigenschaften auf. Der magneto-optische Sensor 28 ist über einen Lichtleiter 30 mit einer optischen Sende- und Empfangseinheit 32, welche auch als optischer Transceiver bezeichnet wird, verbunden. Der Lichtleiter 30 weist Lichtleitfasern auf, welche polarisationserhaltend ausgeführt sind. Die optische Sende- und Empfangseinheit 32 umfasst eine Lichtquelle 34, welche ein polarisiertes Lichtsignal Lp erzeugt. Beispielsweise wird das Licht von einem Polarisator polarisiert. Das polarisierte Lichtsignal Lp wird von der reflektierenden Schicht 28b des magneto-optischen Sensors 28 reflektiert, wobei das reflektierte Lichtsignal Lr auf eine Detektionseinheit 36 trifft. Die Detektionseinheit 36 weist beispielsweise einen opto-elektronischen Wandler mit einem vorgeschalteten Polarisationsfilter auf, welche das reflektierte Lichtsignal Lr filtert und in ein elektrisches Signal umwandelt. Insbesondere wird eine Lichtintensität des reflektierten Lichtsignals Lr über zumindest eine lichtempfindliche Diode, z.B. Fotodiode oder Pin-Diode, in einen Strom konvertiert. Der Lichtleiter 30 ist über einen Steckverbinder 38 mit dem Gehäuse 26 des Halbleitermoduls 2 verbunden. Das elektrische Signal wird in einer Auswerteeinheit 40 weiterverarbeitet, wobei anhand einer Polarisation des reflektierten Lichtsignals Lr ein Strom ermittelt wird. Die Auswerteeinheit 40 weist eine Steuereinheit 42 auf.

In der Auswerteeinheit 40 liegen parallel zu den zeitlichen Magnetfeld Messungen H(t) des magneto-optischen Sensors 28 Ansteuer-Impulse, insbesondere Gate-Signale, vor, sodass transiente Stromsignale, z.B. mit einer Amplituden Dynamik von mindestens 100 und einer Anstiegszeit im Bereich von maximal 10 $\mu$m, erfassbar sind. Eine instantane Leistung ist ebenso ermittelbar.

Die Messung eines Polarisationswinkels F(t) ist der Ausgangpunkt und in einem Aussteuerbereich des magneto-optischen Sensors 28 ergibt sich zu jedem Zeitpunkt t ein linearer Zusammenhang zur Stromstärke I(t):

$$F(t) = C_{MO} \cdot H(t) = C_{MO} \cdot I(t)/(2\pi \cdot r)$$

Bei Berücksichtigung von Eigentemperatureffekten der eingebetteten Schichten wird zunächst der Abstand r und der Polarisationswinkel $C_{MO} = f(T)$ temperaturabhängig.

$$F(t,T) = C_{MO}(T) \cdot I(t)/(2\pi \cdot r(T))$$

Die Temperaturabhängigkeit für den Polarisationswinkel kann alternativ nahe I(t)=0 bestimmt und als Korrekturterm herangezogen werden. Ist der aktuelle Strom I(t) bekannt, kann, in Gegenrichtung gerechnet, eine Temperatur ermittelt werden.

Die magneto-optischen Dünnschichten weisen genügend Sensitivität zur Erfassung von typischen Stromdichten, d.h. von Magnetfeldern im Bereich von Halbleiterelementen 4, auf. Ferner erfolgen magneto-optische Effekte in der Regel hochdynamisch, sodass magneto-optische Schichten schnellen Halbleiter-StromTransienten bei An- und Abschaltvergängen leicht folgen können. Insbesondere durch schnelle lichtempfindliche Dioden, wie Fotodioden, ist mit wenig Schaltungsaufwand galvanisch sicher getrennte lokale Stromtransiente erfassbar.

Da ein Polarisationsverhalten des magneto-optischen Sensors 28 temperaturabhängig ist, wobei eine Polarisation mit zunehmender Temperatur abnimmt, kann durch eine, insbesondere gleichzeitige, Temperaturmessung des magneto-optischen Sensors 28 eine Genauigkeit der Ermittlung des Stromes verbessert werden. Hierzu wird eine Temperatur des magneto-optischen Sensors 28, beispielsweise optisch über ein zusätzliches IR-Lichtsignal, ermittelt. Daraufhin wird der Strom in Abhängigkeit der Temperatur des magneto-optischen Sensors 28 und der Polarisation des reflektierten Lichtsignals Lr ermittelt. Ein Abgleich des temperaturabhängigen Polarisationsverhalten kann empirisch mittels einer Lookup-Table, mittels eines Modells und/oder mit Hilfe eines digitalen Zwillings erfolgen.

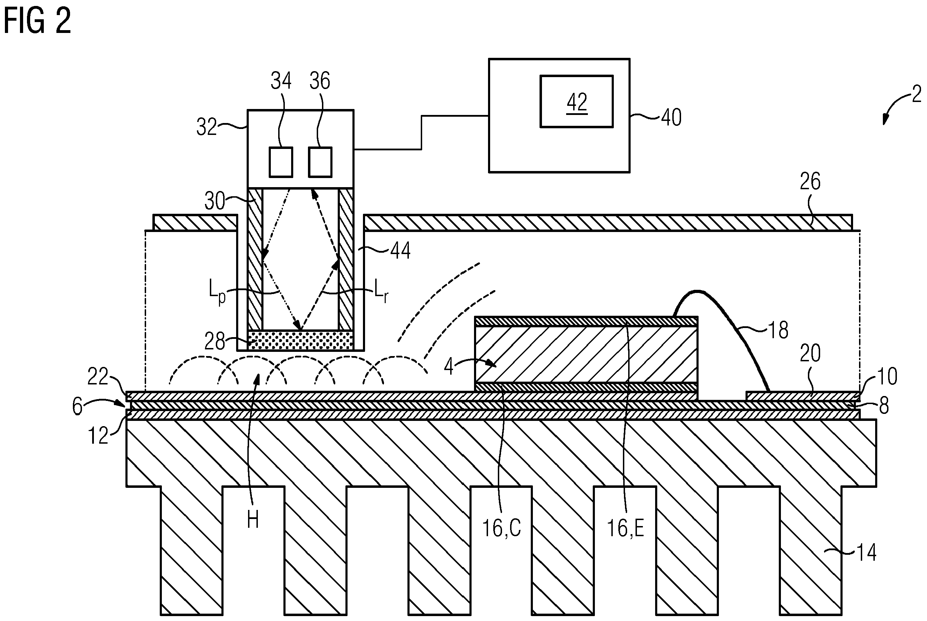

FIG 2 zeigt eine schematische Darstellung einer zweiten Ausgestaltung eines Halbleitermoduls 2 im Querschnitt, wobei ein magneto-optischer Sensor 28 in einer Kavität 44 des Gehäuses 26 oberhalb der zweiten Zuleitung 22 angeordnet ist. Durch die in FIG 2 dargestellte Anordnung ist der magneto-optische Sensor 28 unter Nutzung des Kerr-Effektes konfiguriert zur Überwachung eines Stromes, insbesondere einer Stromtransienten, im Bereich der zweiten Zuleitung 22, wobei der magneto-optische Sensor 28 in einem Magnetfeld H der zweiten Zuleitung 22 angeordnet ist. Die weitere Ausführung des Halbleitermoduls 2 in FIG 2 entspricht der in FIG 1,

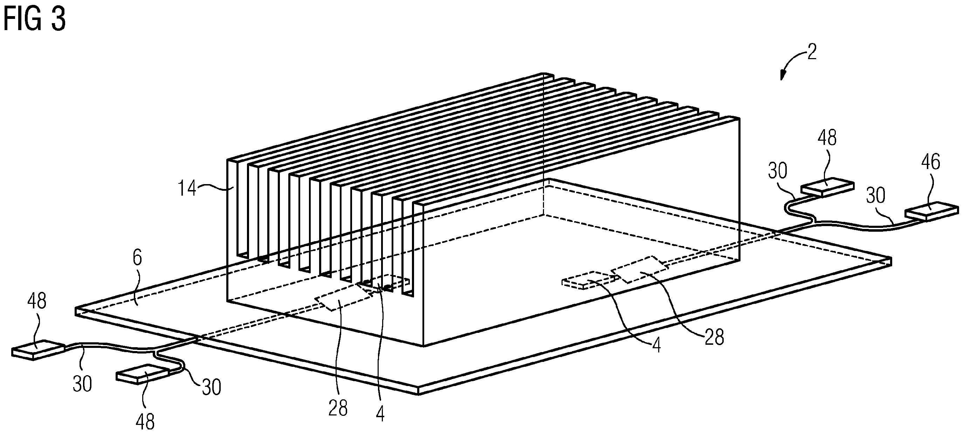

FIG 3 zeigt eine dreidimensionale schematische Darstellung einer dritten Ausgestaltung eines Halbleitermoduls 2. Halbleiterelemente 4 sind auf einem Substrat 6 kontaktiert, wobei ein Kühlkörper 14 auf einer dem Substrat 6 abgewandten Seite der Halbleiterelemente 4 thermisch mit den Halbleiterelementen 4 verbunden ist. Unterhalb der Halbleiterelemente 4 sind magneto-optische Sensoren 28 im Substrat 6 angeordnet, welche als "elektro-optischen Leiterplatte", kurz EOCB, ausgeführt sind. Die magneto-optischen Sensoren 28 sind zur dynamischen Erfassung eines lokalen Magnetfeldes und dessen transientem Verlauf, welches als Maß für die lokale Stromdichte und Halbleitertemperatur $T_{Junction}$ herangezogen wird, konfiguriert. Von einer optischen Sendeeinheit 46 wird ein von einer Lichtquelle 34 generiertes polarisiertes Lichtsignal Lp über einen Lichtleiter zum magneto-optische Sensor 28 geleitet. Das vom magneto-optische Sensor 28 reflektierte Lichtsignal Lr wird über einen weiteren Lichtleiter 30 zu einer optische Empfangseinheit 48, welche eine Detektionseinheit 36 umfasst, geleitet. Insbesondere sind die magneto-optischen Sensoren 28 und Lichtleiter 30 in der EOCB fixiert, sodass Vibrationen, welche eine Detektion von Polarisationsänderungen stören können, unterdrückt werden. Die optischen Sendeeinheiten 46 und optischen Empfangseinheiten 48 sind beispielsweise mit einer gemeinsamen Auswerteeinheit 40 verbunden, welche aus Gründen der Übersichtlichkeit in FIG 3 nicht dargestellt ist. Insbesondere werden die Lichtquellen 34 von einer gemeinsamen Steuereinheit 42 der Auswerteeinheit 40 angesteuert. Die weitere Ausführung des Halbleitermoduls 2 in FIG 3 entspricht der in FIG 1,

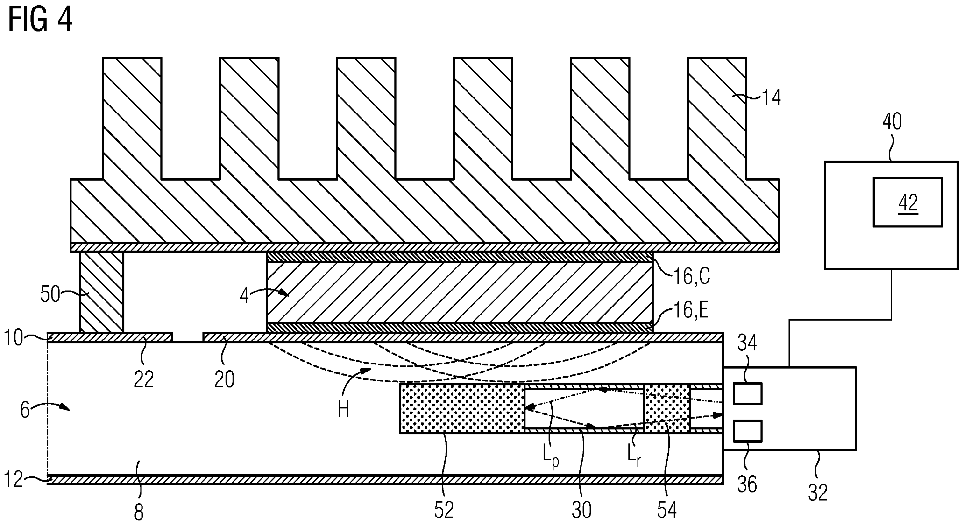

FIG 4 zeigt eine schematische Darstellung einer vierten Ausgestaltung eines Halbleitermoduls 2 im Querschnitt, welches ein Substrat 6 aufweist, auf dem ein beispielhaft als IGBT ausgeführtes Halbleiterelement 4 verbunden ist. Insbesondere ist das Halbleiterelement 4 flip-chip und mittels planarer Aufbau- und Verbindungstechnik auf dem Substrat 6 kontaktiert, wobei der Emitter E mit einer ersten Zuleitung 20 und der Kollektor C über ein Abstandshalteelement 50, auch Umsteiger genannt, mit einer zweiten Zuleitung 22 verbunden ist. Ein Gate-Kontakt des IGBTs ist aus Gründen der Übersichtlichkeit in FIG 4 nicht dargestellt.

Ein magneto-optische Sensor 28, welcher über einen Lichtleiters 30 mit einer optischen Sende- und Empfangseinheit 32 verbunden ist, ist innerhalb des Substrats 6 verlaufend angeordnet. Der magneto-optische Sensor 28 ist zusammen mit einem Lichtleiter 30 in einer Aussparung 52 einer dielektrischen Materiallage 8 des Substrats 6 integriert. Von der optischen Sende- und Empfangseinheit 32 wird ein von einer Lichtquelle 34 generiertes polarisiertes Lichtsignal Lp über einen Polarisator 54 und den Lichtleiter zum magneto-optische Sensor 28 geleitet. Das vom magneto-optischen Sensor 28 reflektierte Lichtsignal Lr wird über den Lichtleiter 30 und den Polarisator 54 zurück zur optischen Sende- und Empfangseinheit 32 reflektiert. In der Auswerteeinheit 40 wird anhand einer Polarisation des reflektierten Lichtsignals Lr ein Strom ermittelt. Die weitere Ausführung des Halbleitermoduls 2 in FIG 4 entspricht der in FIG 3.

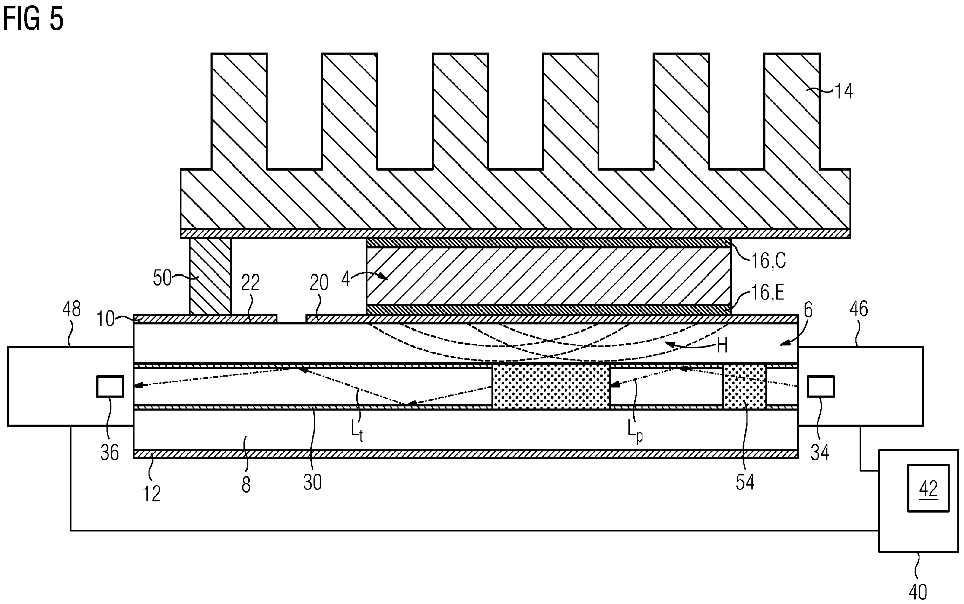

FIG 5 zeigt eine schematische Darstellung einer vierten Ausgestaltung eines Halbleitermoduls 2 im Querschnitt, wobei ein von einer Lichtquelle 34 generiertes polarisiertes Lichtsignal Lp von einer optischen Sendeeinheit 46 über einen Polarisator 54 und einen Lichtleiter 30 zum magneto-optische Sensor 28 geleitet wird. Das polarisierte Lichtsignal Lp vom magneto-optischen Sensor 28 transmittiert, wobei das transmittierte Lichtsignals Lt über einen Lichtleiter 30 zu einer optischen Empfangseinheit 48, welche eine Detektionseinheit 36 umfasst, geleitet wird. In der Auswerteeinheit 40 wird anhand einer Polarisation des transmittierten Lichtsignals Lt ein Strom ermittelt. Die weitere Ausführung des Halbleitermoduls 2 in FIG 4 entspricht der in FIG 4.

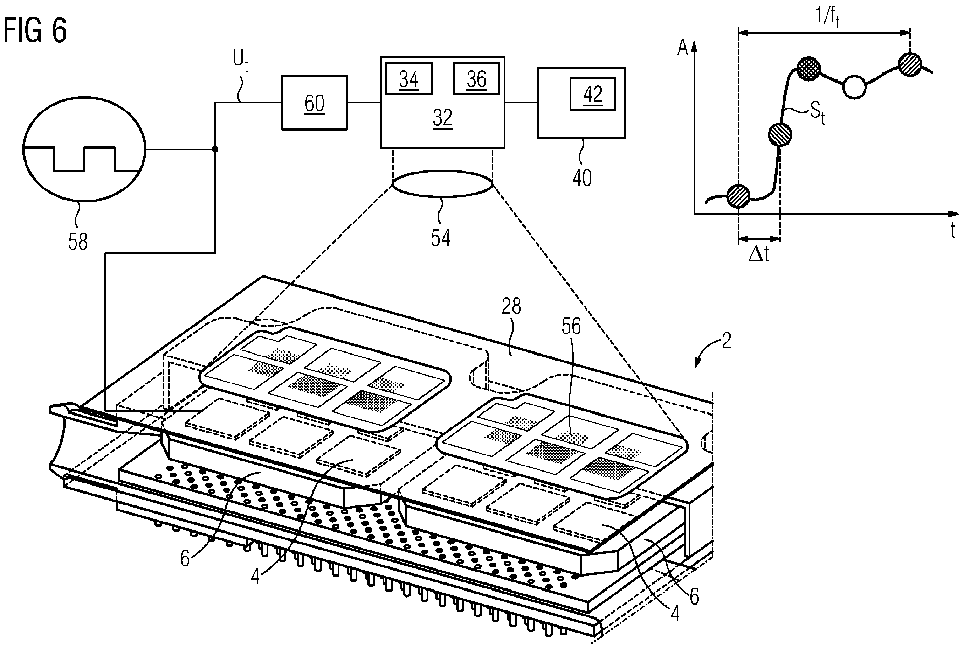

FIG 6 zeigt eine schematische Darstellung einer sechsten Ausgestaltung eines Halbleitermoduls 2. Die optische Sende- und Empfangseinheit 32 ist als Kamera ausgeführt, wobei die Detektionseinheit 36 der Kamera ein zweidimensionales Detektor-Array aufweist zur Ermittlung einer zweidimensionalen Stromdichteverteilung 56 aufweist. Hierzu wird ein magneto-optischer Sensor 28 mit einer großflächigen magneto-optischen Schicht 28 herangezogen. Ein von einer der Kamera zugewiesenen Lichtquelle 34 generiertes polarisiertes Lichtsignal Lp wird über einen Polarisator 54 zum großflächigen magneto-optische Sensor 28 geleitet. Das vom magneto-optischen Sensor 28 reflektierte Lichtsignal Lr wird über den Polarisator 54 zurück zur Kamera reflektiert. In der Auswerteeinheit 40 wird anhand einer Polarisation des reflektierten Lichtsignals Lr ein Strom ermittelt.

Um ein transientes Stromsignal St, welches eine Amplituden Dynamik von mindestens 100 und eine Anstiegszeit im Bereich von maximal 10 $\mu$m aufweist, zu erfassen, wird eine Unterabtastung durchgeführt, welche durch ein von einem Signalgenerator 58 erzeugtes Umrichtertaktsignal Ut der Frequenz ft getriggert wird. Für die Unterabtastung wird das Umrichtertaktsignal Ut über ein Verzögerungsglied 60 um eine Verzögerungszeit $\Delta$t, welche kleiner als 1/ft ist, definiert verzögert. Die weitere Ausführung des Halbleitermoduls 2 in FIG 6 entspricht der in FIG 1.

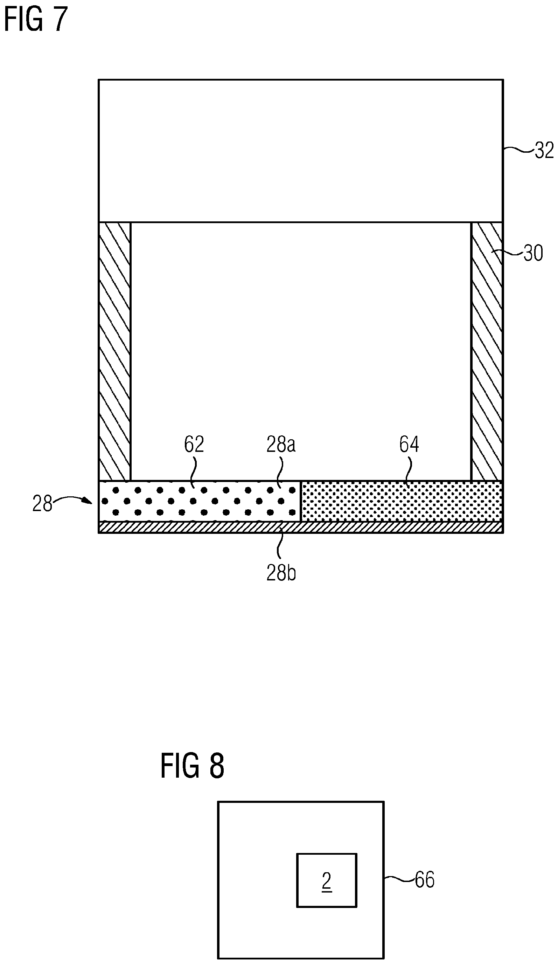

FIG 7 zeigt eine vergrößerte schematische Darstellung eines magneto-optischen Sensors 28, welcher ein erstes magneto-optisches Material 62 und ein zweites magneto-optisches Material 64, welches sich hinsichtlich einer Empfindlichkeit bezüglich der Feldstärke vom ersten magneto-optischen Material 62 unterscheidet, umfasst. Wie in FIG 1 dargestellt, ist der magneto-optische Sensor 28 über einen Lichtleiter 30 mit einer optischen Sende- und Empfangseinheit 32 verbunden. Die mindestens zwei magneto-optischen Materialien 62, 64 sind für unterschiedliche Feldstärken verwendbar, sodass eine Vergrößerung einer Messdynamik erreichbar ist.

FIG 8 zeigt eine schematische Darstellung eines Stromrichters 66 mit einem Halbleitermodul 2. Der Stromrichter 66 kann mehr als ein Halbleitermodul 2 umfassen.

Zusammenfassend betrifft die Erfindung ein Verfahren zum Überwachen zumindest eines Halbleiterelements 4 in einem Halbleitermodul 2, wobei das Halbleitermodul 2 Zuleitungen 20, 22 zur Kontaktierung des Halbleiterelements 4 aufweist. Um dynamische, insbesondere transiente, Vorgänge erfassen zu können, ohne das zumindest eine Halbleiterelement 4 und dessen Peripherie merklich zu beeinflussen, wird vorgeschlagen, dass ein magneto-optischer Sensor 28 im Bereich des Halbleiterelements 4 oder zumindest einer Zuleitung 20, 22 angeordnet ist, wobei ein polarisiertes Lichtsignal Lp vom magneto-optischen Sensor 28 reflektiert wird, wobei anhand einer Polarisation des reflektierten Lichtsignals Lr ein Strom ermittelt wird.

**Patentansprüche**

1. Verfahren zum Überwachen zumindest eines Halbleiterelements (4) in einem Halbleitermodul (2),
   wobei das Halbleitermodul (2) Zuleitungen (20, 22) zur Kontaktierung des Halbleiterelements (4) aufweist,
   wobei ein magneto-optischer Sensor (28) im Bereich des Halbleiterelements (4) oder zumindest einer Zuleitung (20, 22) angeordnet ist,
   wobei ein polarisiertes Lichtsignal (Lp) vom magneto-optischen Sensor (28) reflektiert wird,
   wobei anhand einer Polarisation des reflektierten Lichtsignals (Lr) ein Strom ermittelt wird.

2. Verfahren zum Überwachen zumindest eines Halbleiterelements (4) in einem Halbleitermodul (2),
   wobei das Halbleitermodul (2) Zuleitungen (20, 22) zur Kontaktierung des Halbleiterelements (4) aufweist,
   wobei ein magneto-optischer Sensor (28) im Bereich des Halbleiterelements (4) oder zumindest einer Zuleitung (20, 22) angeordnet ist,
   wobei ein polarisiertes Lichtsignal (Lp) vom magneto-optischen Sensor (28) transmittiert wird,
   wobei anhand einer Polarisation des transmittierten Lichtsignals (Lt) ein Strom ermittelt wird.

3. Verfahren nach einem der Ansprüche 1 oder 2,
   wobei das polarisierte Lichtsignal (Lp) über einen Lichtleiter (30) zum magneto-optischen Sensor (28) geleitet wird.

4. Verfahren nach Anspruch 3,
   wobei zumindest ein Teil des Lichtleiters (30) und der magneto-optische Sensor (28) innerhalb des Substrats (6) verlaufend angeordnet sind,
   wobei das polarisierte Lichtsignal (Lp) innerhalb des Substrats (6) auf den magneto-optischen Sensor (28) geleitet wird.

5. Verfahren nach einem der vorherigen Ansprüche,
   wobei anhand der Polarisation des Lichtsignals (Lr, Lp) eine zweidimensionale Stromdichteverteilung ermittelt wird.

6. Verfahren nach einem der vorherigen Ansprüche,
   wobei der magneto-optischen Sensor (28) einen magneto-optischen Dünnschicht-Film aufweist,
   wobei ein transientes Stromsignal, insbesondere mit einer Amplituden Dynamik von mindestens 100 und einer Anstiegszeit im Bereich von maximal 10 $\mu$m, erfasst wird.

**7.** Verfahren nach Anspruch 6,
wobei das transiente Stromsignal durch Unterabtastung ermittelt wird.

**8.** Verfahren nach Anspruch 7,
wobei die Unterabtastung durch ein Umrichtertaktsignal (Ut) getriggert wird,
wobei das Umrichtertaktsignal (Ut) definiert verzögert wird.

**9.** Verfahren nach einem der vorherigen Ansprüche,
wobei eine Temperatur des magneto-optischen Sensors (28) ermittelt wird,
wobei der Strom in Abhängigkeit der Temperatur des magneto-optischen Sensors (28) und der Polarisation des Lichtsignals (Lr, Lt) ermittelt wird.

**10.** Steuereinheit (42) mit Mitteln zur Durchführung eines Verfahrens nach einem der Ansprüche 1 bis 9.

**11.** Computerprogramm zur Durchführung eines Verfahrens nach einem der Ansprüche 1 bis 9 bei Ablauf in einer Steuereinheit (42) nach Anspruch 10.

**12.** Verwendung eines magneto-optischen Sensors (28) zur Ermittlung eines Stromes in einem Halbleitermodul (2).

**13.** Verwendung nach Anspruch 12,
wobei der magneto-optische Sensor (28) ein erstes magneto-optisches Material (62) und ein zweites magneto-optisches Material (64), welches sich hinsichtlich einer Empfindlichkeit vom ersten magneto-optischen Material (62) unterscheidet, umfasst,
wobei das erstes magneto-optische Material (62) für die Ermittlung eines ersten Stromes verwendet wird,
wobei das zweite magneto-optische Material (64) für die Ermittlung eines zweiten Stromes verwendet wird und wobei der zweite Strom höher als der erste Strom ist.

**14.** Halbleitermodul (2) aufweisend:

   - zumindest ein Halbleiterelement (4) und Zuleitungen (20, 22) zur Kontaktierung des Halbleiterelements (4),
   - eine Lichtquelle (34), welche zur Erzeugung eines polarisierten Lichtsignals (Lp) konfiguriert ist,
   - einen magneto-optischen Sensor (28), welcher im Bereich des Halbleiterelements (4) oder zumindest einer Zuleitung (20, 22) angeordnet ist und welcher konfiguriert ist, das von der Lichtquelle (34) erzeugte polarisierte Lichtsignal (Lp) zu reflektieren,
   - eine Detektionseinheit (36), welche zur Umwandlung des reflektierten Lichtsignals (Lr) in ein elektrisches Signal konfiguriert ist,
   - eine Auswerteeinheit (40), welche konfiguriert ist anhand einer Polarisation des reflektierten Lichtsignals (Lr) einen Strom zu ermitteln.

**15.** Halbleitermodul (2) aufweisend:

   - zumindest ein Halbleiterelement (4) und Zuleitungen (20, 22) zur Kontaktierung des Halbleiterelements (4),
   - eine Lichtquelle (34), welche zur Erzeugung eines polarisierten Lichtsignals (Lp) konfiguriert ist,
   - einen magneto-optischen Sensor (28), welcher im Bereich des Halbleiterelements (4) oder zumindest einer Zuleitung (20, 22) angeordnet ist und welcher konfiguriert ist, das von der Lichtquelle (34) erzeugte polarisierte Lichtsignal (Lp) zu transmittieren,
   - eine Detektionseinheit (36), welche zur Umwandlung des transmittierten Lichtsignals (Lt) in ein elektrisches Signal konfiguriert ist,
   - eine Auswerteeinheit (40), welche konfiguriert ist anhand einer Polarisation des transmittierten Lichtsignals (Lt) einen Strom zu ermitteln.

**16.** Halbleitermodul (2) nach einem der Ansprüche 14 oder 15, aufweisend einen Lichtleiter (30), welcher zur Verbindung der Lichtquelle (34) und/oder der Detektionseinheit (36) mit dem magneto-optischen Sensor (28) ausgeführt ist.

**17.** Halbleitermodul (2) nach Anspruch 16,
aufweisend ein Substrat (6), auf welcher zumindest ein Halbleiterelement (4) über die Zuleitungen (20, 22) kontaktiert ist und
wobei zumindest ein Teil des Lichtleiters (30) und der magneto-optische Sensor (28) innerhalb des Substrats (6) verlaufend angeordnet sind.

18. Halbleitermodul (2) nach einem der Ansprüche 14 bis 17, wobei der magneto-optischer Sensor (28) maximal 1 mm entfernt vom Halbleiterelement (4) oder zumindest einer Zuleitung (20, 22) angeordnet ist.

19. Halbleitermodul (2) nach einem der Ansprüche 14 bis 18, wobei der magneto-optische Sensors (28) ein erstes magneto-optisches Material (62) und ein zweites magneto-optisches Material (64), welches sich hinsichtlich einer Empfindlichkeit vom ersten magneto-optischen Material (62) unterscheidet, umfasst.

20. Halbleitermodul (2) nach einem der Ansprüche 14 bis 19, wobei der magneto-optischen Sensor (28) einen magneto-optischen Dünnschicht-Film aufweist, welcher zur Erfassung eines transienten Stromsignal, insbesondere mit einer Amplituden Dynamik von mindestens 100 und einer Anstiegszeit im Bereich von maximal 10 $\mu$m, konfiguriert ist.

21. Stromrichter (66) mit mindestens einem Halbleitermodul (2) nach einem der Ansprüche 14 bis 20.

FIG 1

FIG 2

FIG 3

EP 4 050 347 A1

# FIG 4

FIG 5

EP 4 050 347 A1

FIG 6

FIG 7

FIG 8

**Europäisches Patentamt**
**European Patent Office**
**Office européen des brevets**

## EUROPÄISCHER RECHERCHENBERICHT

Nummer der Anmeldung

EP 21 15 9313

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 358 359 A1 (SIEMENS AG [DE]) 8. August 2018 (2018-08-08) | 1-4, 6-12, 14-18, 20,21 | INV. G01R15/24 |
| Y | * Zusammenfassung; Abbildungen 2-5 * | 5 | |
| A | * Absätze [0001], [0005] - [0016], [0018] - [0026] * | 13,19 | |
| | ----- | | |
| Y | ARAKELYAN SHANT ET AL: "Direct current imaging using a magneto-optical sensor", SENSORS AND ACTUATORS A: PHYSICAL, ELSEVIER BV, NL, Bd. 238, 11. Januar 2016 (2016-01-11), Seiten 397-401, XP029399655, ISSN: 0924-4247, DOI: 10.1016/J.SNA.2016.01.002 * Zusammenfassung * * Sections 1 and 2 * | 5 | |
| | ----- | | |
| A | DE 10 2012 002984 A1 (NORTHROP GRUMMAN LITEF GMBH [DE]) 22. August 2013 (2013-08-22) * Absätze [0001] - [0003], [0022], [0032], [0038], [0044], [0056] * | 1-21 | RECHERCHIERTE SACHGEBIETE (IPC) G01R |
| | ----- | | |

Der vorliegende Recherchenbericht wurde für alle Patentansprüche erstellt

| Recherchenort | Abschlußdatum der Recherche | Prüfer |
|---|---|---|
| München | 9. August 2021 | Kleiber, Michael |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 21 15 9313

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-08-2021

| Im Recherchenbericht angeführtes Patentdokument | Datum der Veröffentlichung | Mitglied(er) der Patentfamilie | Datum der Veröffentlichung |
|---|---|---|---|
| EP 3358359 A1 | 08-08-2018 | CN 108377608 A<br>EP 3358359 A1<br>US 2018217186 A1 | 07-08-2018<br>08-08-2018<br>02-08-2018 |
| DE 102012002984 A1 | 22-08-2013 | DE 102012002984 A1<br>EP 2629102 A2<br>US 2013234698 A1 | 22-08-2013<br>21-08-2013<br>12-09-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **KOSCHNY, MARCO ; LINDNER, MORRIS ; RICHERT, HENDRYK, QUALITY.** *Magneto-Optical Sensors,* 2012, vol. 51, ISSN 03609936, 6-9
- **SHINICHI OHKOSHI ; KENTA IMOTO ; ASUKA NAMAI ; MARIE YOSHIKIYO ; SEIJI MIYASHITA ; HONGSONG QIU ; SHODAI KIMOTO ; KOSAKU KATO ; MAKOTO NAKAJIMA.** Rapid Faraday Rotation on $\varepsilon$-Iron Oxide Magnetic Nanoparticles by Visible and Terahertz Pulsed Light. *Journal of the American Chemical Society,* 2019, vol. 141 (4), 1775-1780
- Rapid Faraday Rotation on $\varepsilon$-Iron Oxide Magnetic Nanoparticles by Visible and Terahertz Pulsed Light. *Magneto-Optical Sensors*